# FASCICULE DE BREVET EUROPEEN

(11) **EP 3 610 942 B1**
(45) Date de publication et mention de la délivrance du brevet: **05.10.2022**
(21) Numéro de dépôt: 18189154.0
(22) Date de dépôt: 15.08.2018
(51) Int. Cl.: B01J 3/03, C23C 16/44

(54) **BRIDE ANTICONTAMINATION POUR MACHINE A PARYLENE**
ANTIKONTAMINATIONSFLANSCH FÜR PARYLEN-MASCHINE
ANTI-CONTAMINATION FLANGE FOR PARYLENE MACHINE

(43) Date de publication de la demande: 19.02.2020
(73) Titulaire: Comelec S.A., 2301 La Chaux-de-Fonds (CH)
(72) Inventeur: BOURGEOIS, Florian, 2301 La Chaux-de-Fonds (CH); BOGAR, Jacques, 2301 La Chaux-de-Fonds (CH); REDOUTEY, Pierre, 2301 La Chaux-de-Fonds (CH); DAMSIR, Hicham, 2301 La Chaux-de-Fonds (CH)
(74) Mandataire: Poindron, Cyrille

(56) Documents cités:
- EP-A2- 1 453 079
- JP-A- H03 208 334
- JP-A- H03 233 294
- JP-A- H10 168 571
- KR-A- 20050 079 564
- US-A- 4 945 856
- US-A- 5 958 510
- US-A1- 2006 105 107
- US-A1- 2014 165 909
- FORTIN ET AL: "Deposition Equipment", CHEMICAL VAPOR DEPOSITION POLYMERIZATION, THE GROWTH AND PROPERTIES OF PARYLENE THIN FILMS,, PAGE(S) 9 - 22 , 1 janvier 2004 (2004-01-01), XP009511315, ISBN: 978-1-4020-7688-6 Extrait de l'Internet: URL:https://www.springer.com/gp/book/97814 02076886

## Description

La présente invention concerne de manière générale une bride de connexion ou un couvercle monté sur une machine de dépôt sous vide de type CVD (« Chemical Vapour Déposition » ou dépôt chimique en phase vapeur), en particulier de Parylène (poly-paraxylylene).

Il est connu dans l'art antérieur des dispositifs de dépôt de Parylène sous vide. Le document US5 958 510 divulgue une machine de dépôt de Parylène dans laquelle les parois sont chauffées en particulier au niveau de joints de connexion ou joints de bride situés à proximité d'un couvercle par exemple. Les documents US2006105107 et JPH03208334 divulguent un réacteur pour réduire les particules et pour semi-conducteur. En outre, le document KR20050079564 divulgue un appareil de dépôt chimique en phase vapeur à basse pression utilisé pour la fabrication de dispositifs semi-conducteurs. Le document JPH10168571 divulgue un dispositif de refroidissement du joint torique. Le document JPH03233294 divulgue un appareil de traitement thermique.

En contrepartie, ce système présente notamment l'inconvénient de ne pas permettre une bonne gestion de la machine de dépôt en terme de température, car la chambre sous vide est perturbée par la chaleur des parois chauffées. Dans ce cas, la température de la chambre augmente, ainsi que celle des pièces et le rendement du procédé baisse, la condensation des vapeurs étant fortement réduite. Il faut alors maintenir la pièce à revêtir à une température modérée, inférieure à environ 40°C. Ce refroidissement dédié aux pièces à revêtir présente l'inconvénient d'être difficile à réaliser pour des pièces en trois dimensions ou de forme complexe, en procédé « batch », c'est-à-dire en traitement par lot de pièces. Il peut être cité comme exemple de pièce de forme complexe à revêtir un capteur, un implant médical ou une carte électronique, en particulier une carte électronique en trois dimensions. Un chauffage inadéquat des joints entraîne un dépôt de Parylène sur ceux-ci et oblige à un remplacement des joints fréquent, voire à chaque utilisation de la machine, après un cycle d'ouverture et de fermeture de la machine. De plus, un chauffage inadéquat du joint et de la zone à proximité du joint entraîne, lors de l'ouverture de la machine après dépôt, un arrachement ou délamination du film de Parylène déposé sur ceux-ci ou à leur proximité, et une pollution de la machine par génération de particules, dégradant les performances du procédé de dépôt sous vide de Parylène, notamment pour l'utilisation ultérieure.

Un but de la présente invention est de répondre aux inconvénients du document de l'art antérieur mentionné ci-dessus et en particulier, tout d'abord, de proposer un dispositif de connexion pour machine à Parylène réduisant la pollution à l'utilisation de la machine, ainsi que lors des phases d'ouverture et de fermeture de la machine, en permettant d'améliorer la performance du procédé en terme de gestion de température et de qualité, tout en réduisant les coûts de maintenance.

L'invention est définie par les revendications. Pour cela, l'invention concerne un dispositif de connexion pour machine de dépôt sous vide,
la machine comprenant une première pièce et une deuxième pièce à connecter ensemble par le dispositif pour former une cavité à vide,
le dispositif comprenant :
   - des moyens de chauffage,
   - un joint de bride,
   - une première portion de connexion de la première pièce, comprenant une première face d'appui, et
   - une deuxième portion de connexion de la deuxième pièce, comprenant une deuxième face d'appui,
dans laquelle lesdites portions de connexion sont agencées pour être connectées l'une à l'autre au niveau de leur face d'appui, et
l'une ou l'autre desdites portions de connexion comprend un logement de joint agencé pour recevoir le joint de bride,
caractérisé en ce que :
   - les moyens de chauffage sont agencés pour chauffer le logement de joint, et
le dispositif comprend en outre des moyens d'isolation agencés pour limiter une conduction de chaleur depuis les moyens de chauffage vers la cavité à vide, et dans lequel les moyens d'isolation comprennent, au niveau des portions de connexion, des évidements séparés par des parois fines et agencées entre les moyens de chauffage et la cavité.

Ceci permet de proposer un dispositif de connexion, également appelé bride anticontamination permettant d'éviter la condensation et le dépôt de Parylène sur le joint de bride et à proximité au niveau des portions de connexion, et d'éviter alors un arrachement ou délamination du film de Parylène à l'ouverture de la bride et de limiter ou réduire la pollution.

En d'autres termes, la cinétique de dépôt baisse quand la température augmente. La température des surfaces joue un rôle sur le coefficient de collage des espèces réactives à l'origine du dépôt du film. Ainsi, dans le cas des matériaux de type Parylène, en chauffant une surface au-delà de 120 à 150°C, la vitesse de dépôt est très réduite ou nulle.

De plus, ceci permet d'améliorer les performances de la machine en terme de gestion de la température parfaitement contrôlée, en évitant une conduction de chaleur depuis les moyens de chauffage vers la cavité, ce qui pourrait perturber le procédé de dépôt sous vide. En d'autres termes, les moyens d'isolation sont agencés pour isoler la cavité à vide des moyens de chauffage afin d'optimiser la qualité de dépôt avec un contrôle indépendant.

Ainsi, ceci permet de proposer un réacteur de dépôt sous vide avec des parois « froides », entre -20°C et 50°C typiquement, ou entre - 20°C et 150°C, sans être limité à ces valeurs, avec une grande uniformité de température des pièces à revêtir, en évitant le recours à un dispositif de refroidissement dédié aux pièces à revêtir. Ceci est particulièrement adapté aux réacteurs procédant par « batch » c'est-à-dire par lot de pièces, en particulier de pièces de formes complexes, et peut être utilisé sur des réacteurs dans lequel le dispositif de connexion est d'une taille similaire à la taille de chambre de dépôt, ce qui est très efficace thermiquement et en terme de productivité.

Avantageusement, les moyens d'isolation agencés pour limiter la conduction de chaleur comprennent au moins un logement de refroidissement agencé entre la cavité et les moyens de chauffage, et agencé pour recevoir des moyens de refroidissement, tels qu'une circulation de fluide de refroidissement.

Ceci permet de proposer une bride anticontamination permettant d'améliorer les performances de la machine en terme de procédé, de sorte à améliorer la qualité des pièces sur lesquelles un dépôt de Parylène est réalisé. En d'autres termes, les moyens d'isolation agencés pour limiter la conduction thermique font obstacle à la diffusion de chaleur entre les moyens de chauffage et la cavité.

Avantageusement, les portions de connexion comprennent des évidements séparés par des parois fines et agencés entre les moyens de chauffage et la cavité.

Ceci permet d'améliorer les performances de la machine en terme de gestion de la température dans l'enceinte de traitement, avec un coût réduit, tout en assurant une rigidité suffisante de la bride de connexion à l'aide des parois fines, telles que des goussets ou des renforts. Les évidements ou nervures permettent de limiter la conduction thermique tout en garantissant une tenue mécanique suffisante pour supporter les contraintes engendrées par la mise sous vide de la cavité (typiquement 0.01 à 10 microbar).

Avantageusement, au moins une des portions de connexion comprend une portion biseautée ou une portion étagée au niveau de la face d'appui du côté de la cavité, de sorte à réaliser une entaille en forme de V ou étagée lorsque la première et la deuxième portion de connexion sont connectées entre elles.

Avantageusement, au moins une des portions de connexion comprend une portion étagée au niveau de la face d'appui du côté de la cavité, de sorte à éviter un contact au niveau de la portion étagée lorsque la première et la deuxième portion de connexion sont connectées entre elles.

Ceci permet de proposer un dispositif de connexion ou une bride anticontamination avec un surface de contact ou d'appui en retrait ou diminuée de sorte à éviter une formation de film de Parylène au niveau de la portion biseautée ou étagée, et ainsi éviter tout arrachement de film ou dépôt de Parylène au niveau de la portion biseautée ou étagée, lors de l'ouverture.

Avantageusement, le dispositif de connexion comprend en outre des moyens d'injection de gaz neutre, tel qu'un injecteur de gaz neutre, agencés au niveau du logement de joint, du côté de la cavité, de sorte à obtenir un confinement du joint par surpression de gaz neutre.

Avantageusement, les moyens d'injection de gaz sont agencés pour injecter un gaz neutre, tel que de l'Argon, à une pression préférentiellement entre 10 et 100 microbar supérieure à la pression de la cavité sous vide, lors de la phase de dépôt du film.

Avantageusement, les moyens d'injection de gaz comprennent un réseau d'injection de gaz disposé sur un diamètre inférieur au diamètre du logement de joint ou une gorge d'injection continue.

Avantageusement, les moyens d'injection de gaz sont agencés entre le logement de joint et la cavité, de sorte à réaliser un confinement par surpression du joint.

Ceci permet de réaliser le confinement du joint par surpression locale au niveau du logement de joint ou du contact du joint sur une face d'appui opposée, de sorte à éviter un dépôt de Parylène au niveau du joint ou à proximité immédiate.

En d'autres termes, ceci permet d'obtenir un confinement du joint par surpression de gaz neutre, et évite la diffusion des espèces réactives vers le joint, et le dépôt de film au niveau du joint ou à proximité immédiate. Ceci évite la pollution par arrachement de film de Parylène au moment de l'ouverture du dispositif de connexion.

Avantageusement, le logement de joint est agencé à une distance prédéterminée de la cavité.

Avantageusement, le joint est agencé entre les portions de connexion, au niveau de leur face d'appui de sorte à permettre l'étanchéité de la cavité.

Avantageusement, le joint présente une dimension caractéristique, tel qu'un diamètre de tore ou une section, et le joint est agencé à une distance de la cavité au moins égale au double de la dimension caractéristique.

Ceci permet de proposer un espace suffisant pour installer les moyens d'isolations. En d'autres termes, les moyens d'isolation sont agencés entre la cavité et le joint et les moyens de chauffage.

Avantageusement, le dispositif de connexion comprend en outre des moyens de fixation de sorte à fixer la première portion de connexion avec la deuxième portion de connexion.

Ceci permet de réaliser la fixation des portions de connexion de la bride et ainsi fermer la machine, de sorte à permettre son fonctionnement sous vide.

Avantageusement :
- la première portion de connexion et la première pièce sont réalisées en un seul bloc, ou
- la deuxième portion de connexion et la deuxième pièce sont réalisées en un seul bloc.

Ceci permet une fabrication aisée du dispositif de connexion.

Avantageusement, la deuxième pièce comprend une portion cylindrique, telle qu'une cuve et chacune des portions de connexion présente une forme annulaire agencée pour s'étendre radialement et perpendiculairement à la portion cylindrique vers l'extérieur, et
chacune des portions de connexion comprend :
- un logement circulaire de chauffage agencé pour recevoir les moyens de chauffage, tels que des serpentins chauffants,
- un logement circulaire de refroidissement agencé entre la cavité et les moyens de chauffage, et agencé pour recevoir des moyens de refroidissement, tels qu'une circulation de fluide de refroidissement,
- les évidements, qui sont il séparés par les parois fines agencés entre le logement circulaire de refroidissement et le logement circulaire de chauffage,
- une portion biseautée au niveau de la face d'appui du côté du logement de refroidissement, de sorte à réaliser une entaille en V ou étagée lorsque les portions de connexion sont connectées entre elles, et
dans lequel :
- la deuxième pièce présente un diamètre interne d'au moins 50 mm,
- le logement de joint est agencé au niveau d'un diamètre supérieur d'au moins 20 mm au diamètre interne et,
- la portion biseautée présente une pente sur au moins 5 mm de rayon.

Avantageusement,
- la deuxième pièce présente un diamètre interne d'au moins 250 mm,
- le logement de joint est agencé au niveau d'un diamètre d'au moins 350 mm, et
- la portion biseautée présente une pente sur au moins 15 mm de rayon.

Avantageusement, la première et la deuxième pièce présentent le même diamètre interne.

Ceci permet de proposer un dispositif de connexion ou bride anticontamination permettant d'améliorer le procédé de dépôt sous vide de Parylène, d'éviter la formation d'un film au niveau de la bride et du joint, et d'éviter la pollution de la machine à l'ouverture, tout en réduisant les coûts d'utilisation en production et en maintenance.

Avantageusement, la distance prédéterminée de la cavité est supérieure à 20 mm, préférentiellement supérieure à 30 mm, très préférentiellement supérieure à 40 mm, encore plus préférentiellement supérieure à 50 mm.

Avantageusement, la deuxième pièce présente un diamètre interne de 250 mm et la distance prédéterminée est de 50 mm.

Ceci permet de limiter le transfert thermique des moyens de chauffage vers la cavité, et d'améliorer la performance de la machine en terme de process. La distance prédéterminée est à adapter en fonction de plusieurs paramètres, notamment la taille de la cavité et de la machine, l'efficacité de la structure isolante (type de matériaux, dimensions, épaisseurs résiduelles des évidements), de la température acceptable au niveau du diamètre interne, ou du dimensionnement des moyens de chauffage et de refroidissement.

Un deuxième aspect n'entrant pas dans le cadre de l'objet revendiqué concerne un dispositif de connexion pour machine de dépôt sous vide de gaz réactif, tel que du Parylène,
la machine comprenant une première pièce et une deuxième pièce à connecter ensemble par le dispositif pour former une cavité à vide,
le dispositif comprenant :
   - un joint de bride,
   - une première portion de connexion de la première pièce, comprenant une première face d'appui, et
   - une deuxième portion de connexion de la deuxième pièce, comprenant une deuxième face d'appui,
dans laquelle lesdites portions de connexion sont agencées pour être connectées l'une à l'autre au niveau de leur face d'appui, et l'une ou l'autre desdites portions de connexion comprend un logement de joint agencé pour recevoir le joint de bride,
caractérisé en ce que le logement de joint est agencé à une distance prédéterminée de la cavité, de sorte à former un obstacle à la diffusion du gaz réactif, tel que du Parylène depuis la cavité vers le logement de joint.

Ceci permet de proposer un dispositif de connexion avec un agencement permettant d'éviter un arrachement ou délamination du film de Parylène à l'ouverture de la bride et de limiter ou réduire la pollution.

En d'autres termes, la distance prédéterminée séparant le logement de joint de la cavité forme un obstacle ou une entrave à la diffusion du gaz réactif, en particulier du Parylène, entre la cavité à vide et le logement de joint, le joint et une surface de contact entre les première et deuxième portion de connexion au niveau de leur face d'appui. Ainsi, le gaz réactif, destiné à revêtir par condensation les pièces à revêtir, est empêché de former un film sur le joint ou à sa proximité immédiate.

La distance prédéterminée est définie en tenant compte des paramètres de procédé sous vide, tels que température, pression, type de revêtement ou type de Parylène, pouvoir pénétrant du Parylène, de la cinétique de dépôt, ainsi que des dimensions géométriques et des matériaux du dispositif de connexion et de la machine.

Chaque espèce réactive à l'origine du dépôt du film est associée à un pouvoir de pénétration donné qui n'est pas infini, lié notamment au coefficient de collage ou aux durées de vie des radicaux. Ainsi en réduisant la section au travers de laquelle le gaz réactif peut diffuser et en augmentant la distance à parcourir, on peut rendre une surface inaccessible au gaz réactif, même si elle est comprise dans un volume commun sans barrière matérielle expressément prévue à cette fin.

En d'autres termes, dans ce cas, c'est uniquement l'agencement du logement de joint et du joint à la distance prédéterminée qui forme un obstacle à la diffusion de Parylène jusqu'au joint et au logement de joint. Ainsi, le joint est protégé du dépôt de film et il n'y a pas d'arrachement de film de Parylène à l'ouverture du dispositif de connexion.

Ainsi, ceci permet de proposer un réacteur de dépôt sous vide avec des parois « froides », entre -20°C et 50°C typiquement, ou entre - 20°C et 150°C, sans être limité à ces valeurs, avec une grande uniformité de température des pièces à revêtir, en évitant le recours à un dispositif de refroidissement dédié aux pièces à revêtir. Ceci est particulièrement adapté aux réacteurs procédant par « batch » c'est-à-dire par lot de pièces, en particulier de pièces de formes complexes, et peut être utilisé sur des réacteurs dans lequel le dispositif de connexion est d'une taille similaire à la taille de chambre de dépôt, ce qui est très efficace thermiquement et en terme de productivité.

Avantageusement, au moins une des portions de connexion comprend une portion biseautée ou une portion étagée au niveau de la face d'appui du côté de la cavité, de sorte à réaliser une entaille en forme de V ou étagée lorsque la première et la deuxième portion de connexion sont connectées entre elles.

Ceci permet de proposer un dispositif de connexion ou une bride anticontamination avec un surface de contact ou d'appui en retrait ou diminuée de sorte à éviter une formation de film de Parylène au niveau de la portion biseautée ou étagée, et ainsi éviter tout arrachement de film ou dépôt de Parylène au niveau de la portion biseautée ou étagée, lors de l'ouverture.

Avantageusement, la distance prédéterminée de la cavité est supérieure à 20 mm, préférentiellement supérieure à 30 mm, très préférentiellement supérieure à 40 mm, encore plus préférentiellement supérieure à 50 mm.

Ceci permet de proposer un dispositif de connexion avec un agencement permettant d'éviter un arrachement ou délamination du film de Parylène à l'ouverture de la bride et de limiter ou réduire la pollution.

Un troisième aspect n'entrant pas dans le cadre de l'objet revendiqué concerne un dispositif de connexion pour machine de dépôt sous vide de gaz réactif, tel que du Parylène,
la machine comprenant une première pièce et une deuxième pièce à connecter ensemble par le dispositif pour former une cavité à vide,
le dispositif comprenant :
   - un joint de bride,
   - une première portion de connexion de la première pièce, comprenant une première face d'appui, et
   - une deuxième portion de connexion de la deuxième pièce, comprenant une deuxième face d'appui,
dans laquelle lesdites portions de connexion sont agencées pour être connectées l'une à l'autre au niveau de leur face d'appui, et l'une ou l'autre desdites portions de connexion comprend un logement de joint agencé pour recevoir le joint de bride,
caractérisé en ce que
le dispositif de connexion comprend en outre des moyens d'injection de gaz neutre agencés au niveau du logement de joint, du côté de la cavité, de sorte à former un obstacle à la diffusion du gaz réactif, tel que du Parylène depuis la cavité vers le logement de joint.

Ceci permet de réaliser le confinement du joint par surpression locale au niveau du logement de joint ou du contact du joint sur une face d'appui opposée, de sorte à éviter un dépôt de Parylène au niveau du joint ou à proximité immédiate. Ceci évite la pollution par arrachement de film de Parylène au moment de l'ouverture du dispositif de connexion.

En d'autres termes, une surpression locale permet de réduire la diffusion du Parylène et ainsi confiner des volumes en les rendant inaccessibles aux espèces réactives à l'origine du dépôt d'un film, sans nécessité de barrière solide ou de paroi.

Avantageusement, le logement de joint est agencé à une distance prédéterminée de la cavité, et la distance prédéterminée de la cavité est supérieure à 20 mm, préférentiellement supérieure à 30 mm, très préférentiellement supérieure à 40 mm, encore plus préférentiellement supérieure à 50 mm.

Ceci permet de proposer un dispositif de connexion avec un agencement permettant d'éviter un arrachement ou délamination du film de Parylène à l'ouverture de la bride et de limiter ou réduire la pollution.

La présente invention concerne une machine de dépôt sous vide comprenant au moins un dispositif de connexion selon la présente invention.

Ceci permet de proposer une machine avec un fonctionnement amélioré en terme de gestion de la température de la cavité ou de l'enceinte de dépôt sous vide, en particulier de Parylène qui se dépose à basse température, inférieure à 120 °C, et de manière optimale entre 10 et 50°C. De plus, une telle machine fonctionne avec une pollution réduite en évitant les phénomènes d'arrachement de film de Parylène au niveau de la bride de connexion et de réduire les coûts de maintenance et de fonctionnement.

Un cinquième aspect n'entrant pas dans le cadre de l'objet revendiqué concerne une machine de dépôt sous vide comprenant :
un couvercle,
un fût à connecter avec le couvercle pour former une cavité à vide,
   - des moyens de chauffage,
   - un joint de couvercle,
   - une première portion de connexion du couvercle, comprenant une première face d'appui, et
   - une deuxième portion de connexion du fût, comprenant une deuxième face d'appui,
dans laquelle lesdites portions de connexion sont agencées pour être connectées l'une à l'autre au niveau de leur face d'appui, et
l'une ou l'autre desdites portions de connexion comprend un logement de joint agencé pour recevoir le joint de couvercle,
caractérisée en ce que :
   - le logement de joint est agencé à une distance prédéterminée de la cavité,
   - les moyens de chauffage sont agencés pour chauffer le logement de joint, et
la machine comprend en outre des moyens d'isolation agencés pour limiter une conduction de chaleur depuis les moyens de chauffage vers la cavité à vide.

Ceci permet de proposer une machine avec un fonctionnement amélioré en terme de gestion de la température de la cavité ou de l'enceinte de dépôt sous vide, en particulier de Parylène qui se dépose à basse température, inférieure à 120 °C, et de manière optimale entre 10 et 50°C. De plus, une telle machine fonctionne avec une pollution réduite, permet d'éviter les phénomènes d'arrachement de film de Parylène au niveau du couvercle et de réduire les coûts de maintenance et de fonctionnement. Une telle machine fonctionne ainsi avec des parois froides (c'est-à-dire inférieure à 100°C), ce qui permet de mieux gérer le procédé de dépôt sous vide de Parylène.

Avantageusement, les moyens d'isolation agencés pour limiter la conduction de chaleur e comprennent :
- un logement de refroidissement de couvercle et
- un logement de refroidissement de fût,
agencés entre la cavité et les moyens de chauffage et agencés pour recevoir des moyens de refroidissement.

Avantageusement, les portions de connexion comprennent des évidements séparés par des parois fines et agencés entre les moyens de chauffage et la cavité.

Ceci permet de proposer une machine de dépôt sous vide de Parylène avec un fonctionnement amélioré, en particulier en terme de gestion du profil de température de l'enceinte de traitement, de sorte à améliorer la qualité des pièces traitées.

Avantageusement, au moins une des portions de connexion comprend une portion biseautée au niveau de la face d'appui du côté de la cavité, de sorte à réaliser une entaille en forme de V ou en profil étagé lorsque la première et la deuxième portion de connexion sont connectées entre elles.

Ceci permet de proposer une machine avec un couvercle anticontamination permettant d'améliorer le procédé de dépôt sous vide de Parylène, d'éviter la formation d'un film au niveau du joint de couvercle et au niveau de la portée du joint, et d'éviter la pollution par le film à l'ouverture, tout en réduisant les coûts de maintenance.

Avantageusement, la distance prédéterminée est supérieure à 20 mm, préférentiellement supérieure à 30 mm, très préférentiellement supérieure à 40 mm.

Ceci permet de limiter le transfert thermique des moyens de chauffage vers la cavité, et d'améliorer la performance de la machine en terme de process de dépôt chimique sous vide CVD (« Chemical Vapour Déposition »).

D'autres caractéristiques et avantages de la présente invention apparaîtront plus clairement à la lecture de la description détaillée qui suit d'un mode de réalisation de l'invention donné à titre d'exemple nullement limitatif et illustré par les dessins annexés, dans lesquels :
- la figure 1 représente une machine de dépôt sous vide de Parylène avec un dispositif de connexion selon la présente invention,
- la figure 2 représente une coupe vue en élévation de la machine de dépôt sous vide de Parylène avec le dispositif de connexion,
- la figure 3 représente une vue de dessus simplifiée du dispositif de connexion,
- la figure 4 représente une partie de coupe vue brisée en élévation de la machine de dépôt sous vide de Parylène avec le dispositif de connexion, la coupe brisée passant par un évidement du dispositif de connexion et une paroi fine y associée,
- la figure 5 représente une vue détaillée du dispositif de connexion comprenant des portions biseautées,
- la figure 6 représente une vue détaillée du dispositif de connexion comprenant des portions étagées.

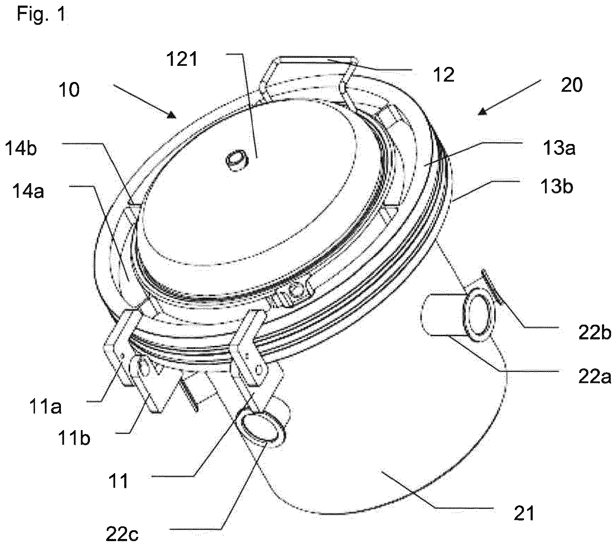

La figure 1 représente une machine de dépôt sous vide de Parylène avec un dispositif de connexion selon la présente invention.

La machine 20 de dépôt sous vide de Parylène comprend une première pièce également appelée dôme de couvercle 121 et une deuxième pièce également appelée chambre de déposition sous vide 21, et un dispositif de connexion, également appelé bride anticontamination ou couvercle anticontamination 10. La chambre de déposition sous vide 21 et le dôme de couvercle 121 sont agencés pour être connectés ensemble par la bride anticontamination 10, pour former une cavité à vide.

La bride anticontamination 10 comprend un système de fixation par pivot 11, composé de deux bras 11a fixés sur la bride, reliés à deux bras 11b fixés sur la chambre de déposition sous vide 21. La chambre de déposition sous vide 21 est équipée de divers accessoires de connexion 22a, 22b, 22c, tels que d'autres brides.

De plus, la bride anticontamination 10 est équipée d'une poignée 12 permettant de faire basculer la bride anticontamination 10 en position ouverte, permettre ainsi l'ouverture de la chambre de déposition sous vide 21. La bride anticontamination 10 est également équipée de moyens de fixation, tel que des clampages, sauterelles, clamps ou vis et écrous (non représentés), de sorte à maintenir la bride anticontamination 10 en position fermée, notamment lors de l'utilisation de la machine 20 de dépôt sous vide de Parylène.

La bride anticontamination 10 comprend en outre une première portion de connexion 13a, également appelée demi-bride supérieure ou demi-bride de couvercle, ainsi qu'une deuxième portion de connexion 13b, également appelée demi-bride inférieure ou demi-bride de chambre. La première portion de connexion 13a et la deuxième portion de connexion 13b comprennent chacune une face d'appui, respectivement première face d'appui et deuxième face d'appui, qui se font face lorsque les portions de connexion 13a, 13b sont connectées ensemble, et donc la bride anticontamination 10 en position fermée.

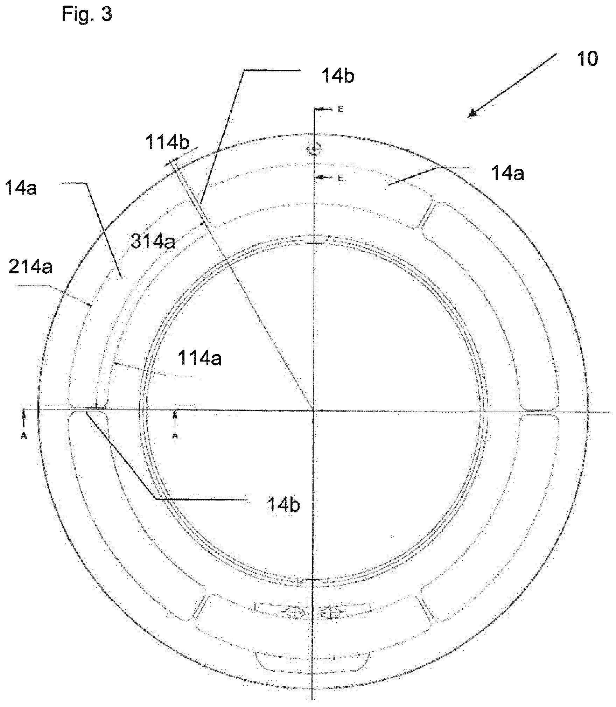

Les portions de connexion 13a, 13b comprennent des évidements 14a séparés par des parois fines 14b, illustrés plus en détail en figure 3.

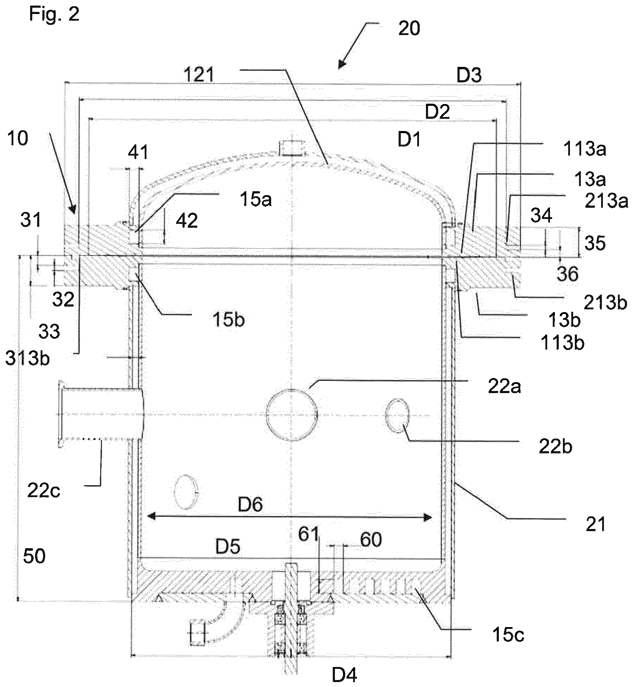

La figure 2 représente une coupe vue en élévation de la machine 20 de dépôt sous vide de Parylène avec le dispositif de connexion également appelé bride anticontamination 10.

La machine 20 de dépôt sous vide de Parylène y est représentée avec sa bride anticontamination 10, sa chambre de déposition sous vide 21 et ses accessoires de connexion 22a, 22b, 22c. La machine 20 de dépôt sous vide de Parylène comprend en outre dans un mode de réalisation avantageux un vaporisateur de dimère de Parylène, un four de pyrolyse, un capteur de pression, un vaporisateur de précurseur d'adhésion, et une trappe froide.

La bride anticontamination 10 est représentée avec sa première portion de connexion 13a, et sa deuxième portion de connexion 13b. Les portions de connexion 13a, 13b ont une forme annulaire s'étendant radialement et perpendiculairement au fût de la chambre de déposition sous vide 21, fût préférentiellement de forme cylindrique. Les portions de connexion 13a, 13b présentent chacune une face d'appui, de sorte à pouvoir être connectées au niveau de leur face d'appui.

Les portions de connexion 13a, 31b comprennent au moins une portion biseautée ou une portion étagée 113a, 113b ou étagée de sorte à réaliser une entaille en V ou étagée au niveau des faces d'appuis, lorsque les portions de connexion 13a, 13b sont connectées entre elles. Ceci permet d'éviter la formation d'un film ou d'un dépôt de Parylène au niveau des portions biseautées 113a, 113b ou étagées lors du fonctionnement de la machine 20, et éviter l'arrachement dudit film de Parylène lors de l'ouverture de la bride anticontamination 10. Cela réduit le risque de pollution par les particules de film arrachées lors de l'ouverture. Les portions biseautées 113a, 113b s'étendent depuis le diamètre de la cavité D6 de 250 mm jusqu'à un diamètre D1 de 290 mm, soit une pente de 1.5° sur une longueur radiale de 20 mm. La pente peut être augmentée à 3° voir 5° dans un mode de réalisation avantageux.

Dans un mode de réalisation avantageux, la première portion de connexion 13a est réalisée en un seul bloc avec le dôme de couvercle 121 et/ou la deuxième portion de connexion 13b est réalisée en un seul bloc avec la chambre de déposition 21.

Les portions de connexion 13a, 13b comprennent chacune un logement circulaire de chauffage 213a, 213b agencés pour recevoir des moyens de chauffage tels que des serpentins chauffants, et un logement de joint 313b agencé pour recevoir un joint de bride de la bride anticontamination 10. Il est entendu qu'il est possible d'utiliser d'autres moyens de chauffage tel que des résistances, ou une circulation de fluide de chauffage pour autant que les logements circulaires de chauffage 213a, 213b soient rendus étanches au niveau du diamètre extérieur D3 de la bride anticontamination 10 mesurant environ 330 mm, et soient connectés à une circulation de fluide chauffant.

Dans un mode de réalisation avantageux, les dimensions du logement de chauffage 213a de la portion de connexion supérieure 13a sont une hauteur de gorge de chauffage 34 de 4 mm, une distance à la face d'appui 36 de 6 mm, pour une hauteur 35 de pièce de connexion 13a de 25 mm. Le fond de gorge de chauffage est situé sur un diamètre D2 de 356 mm. Dans un mode de réalisation avantageux, les dimensions du logement de chauffage 213b de la portion de connexion inférieure 13b sont une hauteur de gorge de chauffage 34 de 4 mm, une distance à la face d'appui 36 de 9 mm pour une hauteur 35 de pièce de connexion 13b de 25 mm. S'agissant de la portion de connexion inférieure 13b, le logement de joint 313b est agencé sur le diamètre D2 de 356 mm, c'est-à-dire à distance de la cavité, dont le diamètre D6 est de 250 mm au niveau de la chambre de déposition 21, dans un mode de réalisation avantageux. Ainsi, le logement de joint 313b est agencé à une distance prédéterminée de la cavité, supérieure à 20 mm, préférentiellement supérieure à 30 mm, et très préférentiellement supérieure à 40 mm. Dans le mode de réalisation représenté, la distance prédéterminée est de 53 mm. Dans ce mode de réalisation avantageux, et dans un mode de fonctionnement, il y a un gradient de température de 110°C entre la température au niveau du joint de 140°C et la température au niveau de la cavité de 30°C. La température au niveau du joint est préférentiellement supérieure à la température régnant dans la cavité.

Dans un mode de réalisation avantageux, le logement de chauffage 213b de la portion de connexion inférieure 13b présente les dimensions suivantes : la hauteur de gorge 32 est de 4 mm, à une distance de la face d'appui 31 de 9 mm du fait de la présence du logement de joint 313b, pour une hauteur 33 de la deuxième portion de connexion de 25 mm. Les faces d'appui lorsque la machine 20 est en fonctionnement est située à un distance 50 du fond de chambre de déposition 21 d'environ 285 mm.

Dans un mode de réalisation avantageux, la chambre de déposition 21 comprend une double paroi de sorte à isoler thermiquement la cavité de l'extérieur, la double paroi présentant une enceinte isolée, comme par exemple un vide isolé de l'intérieur de la cavité, d'une épaisseur de 8 mm, compté entre le diamètre extérieur de l'épaisseur isolante D4 de 266 mm et le diamètre intérieur de l'épaisseur isolante D5. De la même manière, le dôme de couvercle 121 comprend également une double paroi, avec un vide isolé entre celles-ci. Dans un autre mode de réalisation avantageux, la double paroi peut être connectée à un circuit de refroidissement, de sorte à réguler thermiquement la chambre. Dans encore un autre mode de réalisation avantageux, l'enceinte formée par la double paroi intègre un réseau de parois internes ou des serpentins permettant d'optimiser le passage d'un fluide caloporteur ou de régulation, de sorte à maintenir une température parfaitement homogène au niveau des parois internes de la chambre.

La bride de connexion 10 comprend des moyens d'isolation agencés pour limiter une conduction thermique entre les moyens de chauffage et la cavité.

Dans un mode de réalisation avantageux, les moyens d'isolation agencés pour limiter la conduction de chaleur sont des logements de refroidissement 15a, 15b. Ces logements de refroidissement 15a, 15b sont compris dans la bride anticontamination 10, et sont agencés entre les logement de chauffage 213a, 213b et la cavité de la chambre de déposition 21, de sorte à limiter le transfert de chaleur des moyens de chauffage vers la cavité, et ne pas perturber le process de dépôt sous vide de Parylène en terme de gestion de température. Les logements circulaires de refroidissement 15a, 15b ont une hauteur 42 de 11 mm et une profondeur 41 de 8 mm, dans un mode de réalisation avantageux. Les logements circulaires de refroidissement 15a, 15b sont étanches par rapport à la double paroi de la chambre de déposition 21 et du dôme de couvercle 121.

De plus, la chambre de déposition 21 comprend en outre des logements de refroidissements inférieurs 15c agencés au niveau du fond de la cuve de la chambre de déposition sous vide 21, de section rectangulaire d'une hauteur 61 de 12 mm et d'une largeur 60 de 8 mm. Les logements de refroidissement 15a, 15b, 15c sont connectés à un système de circulation de fluide ou liquide de refroidissement, tel qu'une pompe de refroidissement connectée à un échangeur de chaleur non représenté. Le système de circulation de fluide peut également être connecté à la double paroi de sorte à réguler la température de la cavité sous vide.

La figure 3 représente une vue de dessus simplifiée du dispositif de connexion ou bride anticontamination 10.

Comme illustré précédemment, les moyens d'isolation agencés pour limiter la conduction thermique entre les moyens de chauffage et la cavité sont les évidements 14a, séparés par les parois fines 14b, qui réduisent la conduction des moyens de chauffage vers la cavité, tout en permettant d'avoir une rigidité adéquate de la bride anticontamination 10. Les évidements sont ainsi agencés entre les logements de chauffage 213a, 213b et la cavité de la chambre de déposition 21.

Dans un mode de réalisation avantageux, les parois fines 14b peuvent avoir une largeur 114b d'environ 2 à 3 mm, pour une hauteur d'environ 20 à 25 mm. Les évidements peuvent être réalisés sur un diamètre d'environ 300 mm avec une épaisseur d'environ 20 mm, c'est-à-dire sur un premier diamètre d'évidement 114a d'environ 300 mm jusqu'à un deuxième diamètre d'évidemment 214a d'environ 340 mm, avec un angle d'évidemment 314a d'environ 59°, pour une hauteur identique aux parois fines 14b ou à la bride anticontamination 10.

Il est avantageux de réaliser 6 parois fines 14b sur le pourtour de la bride anticontamination 10, de sorte à limiter le transfert thermique des moyens de chauffage vers la cavité, et améliorer le procédé de dépôt sous vide de Parylène. En d'autres termes, sur le pourtour de la bride 10 au niveau des évidements 14a, les évidements 14a représentent un angle cumulé supérieur à 350° et les parois fines 14b représentent un angle cumulé inférieur à 10°. Autrement formulé, les parois fines 14b représentent moins de 3% de la périphérie entre le premier diamètre d'évidement 114a et le deuxième diamètre d'évidement 214a.

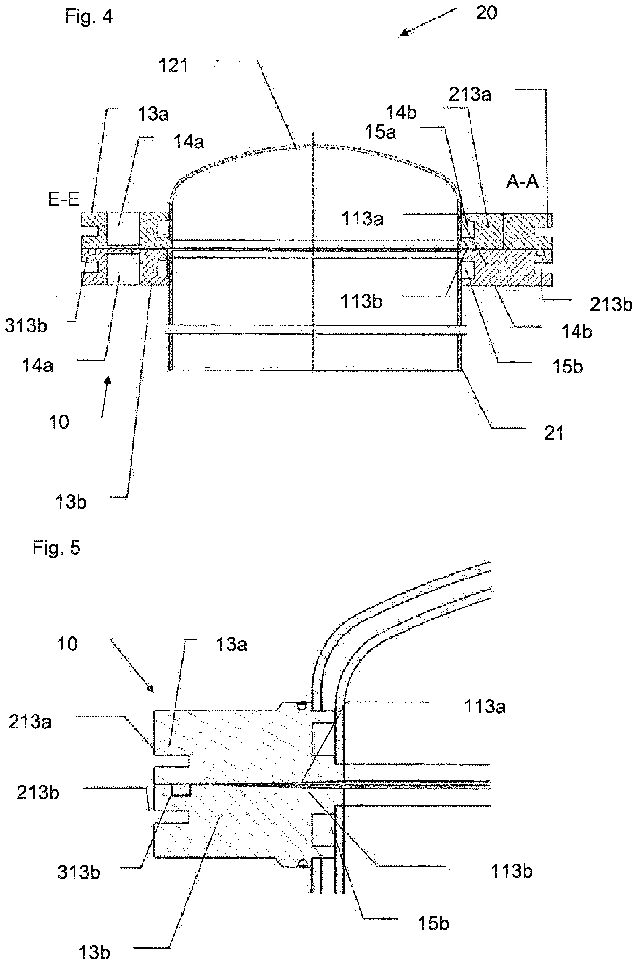

De plus, il est représenté en figure 3 une coupe A-A passant par une des parois fines 14b et une coupe E-E passant par un des évidements 14a, de sorte à pouvoir représenter une coupe brisée en élévation en figure 4.

La figure 4 représente une partie de coupe vue brisée en élévation de la machine 20 de dépôt sous vide de Parylène avec le dispositif de connexion ou bride anticontamination 10, la coupe brisée passant par un des évidements 14a de la bride et par une des parois fines 14b associées.

La partie supérieure de la machine 20 est représentée, avec la bride anticontamination 10 équipée de sa première portion de connexion 13a et de sa deuxième portion de connexion 13b. Le logement circulaire de joint 313b est agencé à distance de la cavité de la chambre de déposition 21, à la distance prédéterminée déjà détaillée précédemment.

Les logements circulaires de chauffage 213a, 213b sont agencés à proximité du logement circulaire de joint 313b, de sorte à recevoir les moyens de chauffage spécifiquement dédiés au chauffage du joint, et éviter une condensation de Parylène au niveau de la portée du joint. Il est entendu par proximité une autre distance prédéterminée inférieure à 40 mm, préférentiellement inférieure à 30 mm, très préférentiellement inférieure à 15 mm.

La bride anticontamination 10 est représentée en vue brisée de sorte à mettre en évidence les évidements 14a, séparés par des parois fines 14b. Les évidements 14a réduisent fortement la conduction thermique des moyens de chauffage logés dans les logements de chauffage 213a, 213b vers la cavité de la chambre de déposition 21 et le dôme de couvercle 121.

Les première et deuxième portions de connexion 13a, 13b comprennent les logements circulaires de refroidissement 15a, 15b, agencés entre la cavité de la chambre de déposition 21 ou le dôme de couvercle 121 et les logements de chauffage 213a, 213b, de sorte à permettre une meilleure gestion de la température au niveau de la cavité sous vide et une meilleure déposition de Parylène sur les pièces à traiter à l'intérieur de la cavité.

Les portions de connexion 13a, 13b comprennent les portions biseautés ou étagées 113a, 113b, agencés au niveau des faces d'appui de la bride anticontamination 10, du côté de la cavité et des logements de refroidissement 15a, 15b.

Ainsi, à chaque cycle de fonctionnement de la machine 20, la bride principale anticontamination 10 ou couvercle anticontamination 10 est ouverte, de sorte à charger ou décharger les pièces à traiter à l'intérieur de la chambre de déposition 21, sous le dôme de couvercle 121. La bride anticontamination 10 selon la présente invention permet donc d'améliorer le process de dépôt sous vide, en améliorant la gestion de la température et limitant la pollution en évitant l'arrachement du film de Parylène au niveau du joint. Aucun film de Parylène ne se dépose au niveau de la portée de joint autour du logement de joint 313b, de sorte qu'il ne peut être arraché à l'ouverture de la bride anticontamination 10.

Les divers accessoires de connexion 22a, 22b, 22c ne sont pas nécessairement ouverts à chaque utilisation ou cycle, ou s'ils sont ouverts, le remplacement de leur joint est plus aisé, ou moins couteux que celui de la bride principale anticontamination 10, en particulier en raison de la taille réduite des accessoires 22a, 22b, 22c.

La figure 5 représente une vue détaillée du dispositif de connexion comprenant les portions biseautées.

Le dispositif de connexion 10 est représenté avec la portion biseautée 113a sur la portion de connexion supérieure 13a et la portion biseautée 113b sur la portion de connexion inférieure 13b. Les portions biseautées 113a, 113b sont réalisées au niveau des faces d'appui des portions de connexion 13a, 13b, de sorte à éviter un éventuel arrachement de film au moment de l'ouverture du dispositif de connexion 10.

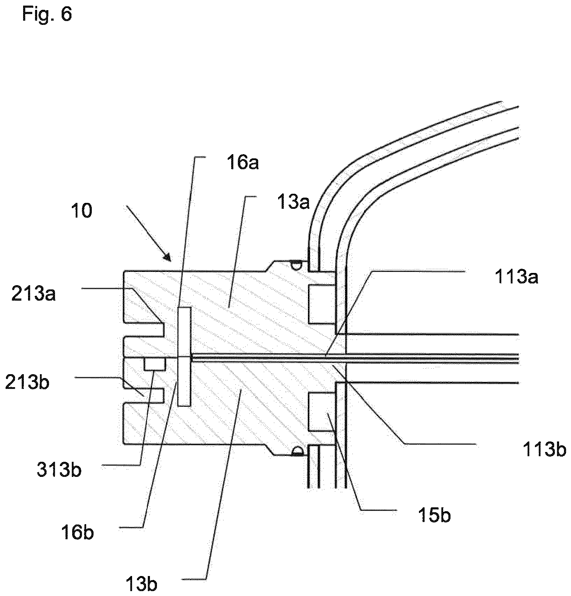

La figure 6 représente une vue détaillée du dispositif de connexion comprenant les portions étagées.

Le dispositif de connexion 10 est représenté avec la portion étagée 113a sur la portion de connexion supérieure 13a et la portion étagée 113b sur la portion de connexion inférieure 13b. Les portions étagées 113a, 113b sont réalisées au niveau des faces d'appui des portions de connexion 13a, 13b, de sorte à éviter un éventuel arrachement de film au moment de l'ouverture du dispositif de connexion 10.

Il est possible, dans les modes de réalisation des figures 5 et 6, de prévoir une portion biseauté ou étagée 113a, 113b sur une seule des portions de connexion 13a, 13b.

Il est en outre possible de prévoir la distance prédéterminée entre la cavité et le logement de joint d'environ 100 mm dans le cas d'une distance entre les portions étagées 113a, 113b d'environ 1 mm. Dans le cas de l'utilisation de Parylène à fort pouvoir pénétrant, tels que VT4 et AF4, il est possible de prévoir la distance prédéterminée à une valeur de 300 mm. L'allongement de la distance prédéterminée prend en considération notamment le dimensionnement des moyens de chauffage, des moyens d'isolation et le pouvoir de pénétration du Parylène notamment.

L'allongement de la distance prédéterminée permet de limiter la quantité d'espèces réactives qui diffusent vers le joint. Ainsi pour une distance donnée entre portions étagées 113a, 113b (ou alternativement pour un angle de biseau donné), et pour chaque type d'espèce réactive, il existe une distance prédéterminée pour laquelle il n'est plus nécessaire de chauffer le joint pour éviter la formation d'un film sur ce dernier et au niveaux des portions de connexion proches du joint. En d'autre termes, l'effet d'éloignement du joint par rapport à la cavité de dépôt peut permettre de réduire voir d'éviter d'avoir recourt à un chauffage du joint, ou de combiner chauffage du joint et éloignement du joint de sorte à obtenir un meilleur dispositif de connexion, notamment en termes de gestion du procédé de dépôt sous vide, de coût, et de maintenance.

De plus, le dispositif de connexion comprend en outre des moyens d'injection de gaz 16a, 16b, tel qu'un injecteur de gaz ou une pluralité de buses d'injection, agencés au niveau du logement de joint 313b, du côté de la cavité.

Les moyens d'injection de gaz 16a, 16b sont agencés pour injecter un gaz neutre, tel que de l'Argon ou tout autre gaz compatible avec le dépôt sous vide de Parylène, à une pression préférentiellement entre 10 et 100 microbar supérieure à la pression de la cavité sous vide lors de la phase de dépôt du film sur les pièces à revêtir. Ils peuvent être positionnés sur chacune des pièces de connexion 13a, 13b ou sur une seule d'entre elles.

Les moyens d'injection de gaz 16a, 16b comprennent dans un mode de réalisation avantageux un réseau d'injection de gaz disposé sur un diamètre inférieur au diamètre du logement de joint 313b ou une gorge d'injection continue. Un confinement par surpression du joint est alors réalisé au niveau du joint et du logement de joint 313b du côté de la cavité.

On comprendra que diverses modifications et/ou améliorations évidentes pour l'homme du métier peuvent être apportées aux différents modes de réalisation de l'invention décrits dans la présente description. En particulier, il est fait référence à la forme en dôme du couvercle, dont la concavité peut être également orientée vers l'intérieur de la cavité, ou qui peut être sous forme de bride pleine sans dôme, également appelé couvercle plat. Il est également fait référence à la possibilité d'avoir une cuve de forme carré ou rectangulaire ou une autre forme, et dans ce cas la forme du dispositif de connexion est adaptée en conséquence. Il est possible de prévoir plusieurs logements de joints sur une même portion de connexion, ou un ou plusieurs logements de joints sur les deux portions de connexion. De plus, il est possible de combiner entre eux les modes de réalisations de sorte à optimiser le fonctionnement et comportement de la machine 20 et de la bride anticontamination 10.

## Revendications

1. Dispositif de connexion (10) pour machine de dépôt sous vide (20),
la machine (20) comprenant une première pièce (121) et une deuxième pièce (21) à connecter ensemble par le dispositif (10) pour former une cavité à vide,
le dispositif (10) comprenant :
- des moyens de chauffage,
- un joint de bride,
- une première portion de connexion (13a) de la première pièce (121), comprenant une première face d'appui, et
- une deuxième portion de connexion (13b) de la deuxième pièce (21), comprenant une deuxième face d'appui,
dans laquelle lesdites portions de connexion (13a, 13b) sont agencées pour être connectées l'une à l'autre au niveau de leur face d'appui, et
l'une ou l'autre desdites portions de connexion (13a, 13b) comprend un logement de joint (313b) agencé pour recevoir le joint de bride,
**caractérisé en ce que** :
- les moyens de chauffage sont agencés pour chauffer le logement de joint (313b), et
le dispositif (10) comprend en outre des moyens d'isolation agencés pour limiter une conduction de chaleur depuis les moyens de chauffage vers la cavité à vide, et
dans lequel les moyens d'isolation comprennent, au niveau des portions de connexion (13a, 13b), des évidements (14a) séparés par des parois fines (14b) et agencés entre les moyens de chauffage et la cavité.

2. Dispositif de connexion (10) selon la revendication précédente, dans lequel les moyens d'isolation agencés pour limiter la conduction de chaleur comprennent au moins un logement de refroidissement agencé entre la cavité et les moyens de chauffage, et agencé pour recevoir des moyens de refroidissement, tels qu'une circulation de fluide de refroidissement.

3. Dispositif de connexion (10) selon l'une quelconque des revendications précédentes, dans lequel au moins une des portions de connexion (13a, 13b) comprend une portion biseautée (113a, 113b) ou une portion étagée au niveau de la face d'appui du côté de la cavité, de sorte à réaliser une entaille en forme de V ou étagée lorsque la première et la deuxième portion de connexion (13a, 13b) sont connectées entre elles.

4. Dispositif de connexion (10) selon l'une quelconque des revendications précédentes, comprenant en outre des moyens d'injection de gaz neutre (16a, 16b) agencés au niveau du logement de joint, du côté de la cavité, de sorte à obtenir un confinement du joint par surpression de gaz neutre.

5. Dispositif de connexion (10) selon l'une quelconque des revendications précédentes, dans lequel:
- la première portion de connexion (13a) et la première pièce (121) sont réalisées en un seul bloc, ou
- la deuxième portion de connexion (13b) et la deuxième pièce (21) sont réalisées en un seul bloc.

6. Dispositif de connexion (10) selon la revendication 1, dans lequel:
la deuxième pièce (21) comprend une portion cylindrique, telle qu'une cuve, et
chacune des portions de connexion (13a, 13b) présente une forme annulaire agencée pour s'étendre radialement et perpendiculairement à la portion cylindrique vers l'extérieur, et
chacune des portions de connexion (13a, 13b) comprend :
- un logement circulaire de chauffage (213a, 213b) agencé pour recevoir les moyens de chauffage, tels que des serpentins chauffants,
- un logement circulaire de refroidissement (15a, 15b) agencé entre la cavité et les moyens de chauffage, et agencé pour recevoir des moyens de refroidissement, tels qu'une circulation de fluide de refroidissement,
- les évidements (14a), qui sont séparés par les parois fines (14b) agencés entre le logement circulaire de refroidissement (15a, 15b) et le logement circulaire de chauffage (213a, 213b),
- une portion biseautée (113a, 113b) au niveau de la face d'appui du côté du logement de refroidissement (15a, 15b), de sorte à réaliser une entaille en V lorsque les portions de connexion (13a, 13b) sont connectées entre elles, et
dans lequel :
- la deuxième pièce (21) présente un diamètre interne d'au moins 50 mm,
- le logement de joint (313b) est agencé au niveau d'un diamètre supérieur d'au moins 20 mm au diamètre interne et,
- la portion biseautée (113a, 113b) présente une pente sur au moins 5 mm de rayon.

7. Dispositif de connexion (10) selon la revendication précédente, dans lequel:
- la deuxième pièce (21) présente un diamètre interne d'au moins 250 mm,
- le logement de joint (313b) est agencé au niveau d'un diamètre d'au moins 350 mm, et
- la portion biseautée (113a, 113b) présente une pente sur au moins 15 mm de rayon.

8. Dispositif de connexion (10) selon l'une quelconque des revendications précédentes, dans lequel le logement de joint est agencé à une distance prédéterminée de la cavité supérieure à 20 mm, préférentiellement supérieure à 30 mm, très préférentiellement supérieure à 40 mm.

9. Machine de dépôt sous vide (20) comprenant au moins un dispositif de connexion (10) selon l'une quelconque des revendications précédentes.

## Patentansprüche

1. Verbindungsvorrichtung (10) für Vakuumabscheidungsmaschine (20),
wobei die Maschine (20) ein erstes Bauteil (121) und ein zweites Bauteil (21) umfasst, die durch die Vorrichtung (10) miteinander zu verbinden sind, um einen Vakuumhohlraum zu bilden,
wobei die Vorrichtung (10) umfasst:
- Heizmittel,
- eine Flanschverbindung,
- einen ersten Verbindungsabschnitt (13a) des ersten Bauteils (121), der eine erste Auflagefläche umfasst, und
- einen zweiten Verbindungsabschnitt (13b) des zweiten Bauteils (21), der eine zweite Auflagefläche umfasst,
wobei die Verbindungsabschnitte (13a, 13b) gestaltet sind, um im Bereich ihrer Auflagefläche miteinander verbunden zu werden, und
der eine oder der andere der Verbindungsabschnitte (13a, 13b) eine Verbindungsaufnahme (313b) umfasst, die gestaltet ist, um die Flanschverbindung aufzunehmen,
**dadurch gekennzeichnet, dass**:
- die Heizmittel gestaltet sind, um die Verbindungsaufnahme (313b) zu erhitzen, und
die Vorrichtung (10) ferner Isolationsmittel umfasst, die gestaltet sind, um eine Wärmeleitung ausgehend von den Heizmitteln hin zu dem Vakuumhohlraum zu begrenzen, und
wobei die Isolationsmittel im Bereich der Verbindungsabschnitte (13a, 13b) Aussparungen (14a) umfassen, die durch feine Wände (14b) getrennt sind und zwischen den Heizmitteln und dem Hohlraum angeordnet sind.

2. Verbindungsvorrichtung (10) nach dem vorhergehenden Anspruch, wobei die Isolationsmittel, die gestaltet sind, um die Wärmeleitung zu begrenzen, mindestens eine Kühlaufnahme umfassen, die zwischen dem Hohlraum und den Heizmitteln angeordnet ist und gestaltet ist, um Kühlmittel, wie beispielsweise einen Umlauf von Kühlfluid, aufzunehmen.

3. Verbindungsvorrichtung (10) nach einem der vorhergehenden Ansprüche, wobei mindestens einer der Verbindungsabschnitte (13a, 13b) einen abgeschrägten Abschnitt (113a, 113b) oder einen abgestuften Abschnitt im Bereich der Auflagefläche auf der Seite des Hohlraums umfasst, derart dass ein V-förmiger oder abgestufter Einschnitt gebildet wird, wenn der erste und der zweite Verbindungsabschnitt (13a, 13b) miteinander verbunden sind.

4. Verbindungsvorrichtung (10) nach einem der vorhergehenden Ansprüche, die ferner Mittel (16a, 16b) zum Einpressen von Neutralgas umfasst, die im Bereich der Verbindungsaufnahme auf der Seite des Hohlraums angeordnet sind, derart dass ein Einschluss der Verbindung durch Neutralgasüberdruck erhalten wird.

5. Verbindungsvorrichtung (10) nach einem der vorhergehenden Ansprüche, wobei:
- der erste Verbindungsabschnitt (13a) und das erste Bauteil (121) in einem einzigen Block hergestellt sind, oder
- der zweite Verbindungsabschnitt (13b) und das zweite Bauteil (21) in einem einzigen Block hergestellt sind.

6. Verbindungsvorrichtung (10) nach Anspruch 1, wobei:
das zweite Bauteil (21) einen zylindrischen Abschnitt, wie beispielsweise ein Gefäß, umfasst, und
jeder der Verbindungsabschnitte (13a, 13b) eine Ringform aufweist, die gestaltet ist, um sich radial und senkrecht zum zylindrischen Abschnitt nach außen zu erstrecken, und
jeder der Verbindungsabschnitte (13a, 13b) umfasst:
- eine ringförmige Heizaufnahme (213a, 213b), die gestaltet ist, um die Heizmittel, wie beispielsweise Heizschlangen, aufzunehmen,
- eine kreisförmige Kühlaufnahme (15a, 15b), die zwischen dem Hohlraum und den Heizmitteln angeordnet ist und gestaltet ist, um Kühlmittel, wie beispielsweise einen Umlauf von Kühlfluid, aufzunehmen,
- Aussparungen (14a), die von dünnen Wänden (14b) getrennt sind, die zwischen der kreisförmigen Kühlaufnahme (15a, 15b) und der kreisförmigen Heizaufnahme (213a, 213b) angeordnet sind,
- einen abgeschrägten Abschnitt (113a, 113b) im Bereich der Auflagefläche auf der Seite der Kühlaufnahme (15a, 15b), derart, dass ein V-förmiger Einschnitt gebildet wird, wenn die Verbindungsabschnitte (13a, 13b) miteinander verbunden sind, und wobei:
- das zweite Bauteil (21) einen Innendurchmesser von mindestens 50 mm aufweist,
- die Verbindungsaufnahme (313b) im Bereich eines Durchmessers angeordnet ist, der um mindestens 20 mm größer als der Innendurchmesser ist, und
- der abgeschrägte Abschnitt (113a, 113b) auf mindestens 5 mm Radius eine Neigung aufweist.

7. Verbindungsvorrichtung (10) nach dem vorhergehenden Anspruch, wobei:
- das zweite Bauteil (21) einen Innendurchmesser von mindestens 250 mm aufweist,
- die Verbindungsaufnahme (313b) im Bereich eines Durchmessers von mindestens 350 mm angeordnet ist, und
- der abgeschrägte Abschnitt (113a, 113b) auf mindestens 15 mm Radius eine Neigung aufweist.

8. Verbindungsvorrichtung (10) nach einem der vorhergehenden Ansprüche, wobei die Verbindungsaufnahme in einem vorbestimmten Abstand von dem Hohlraum angeordnet ist, der größer als 20 mm, vorzugsweise größer als 30 mm, sehr zu bevorzugen größer als 40 mm ist.

9. Vakuumabscheidungsmaschine (20), die mindestens eine Verbindungsvorrichtung (10) nach einem der vorhergehenden Ansprüche umfasst.

## Claims

1. A connection device (10) for a vacuum deposition machine (20),
the machine (20) comprising a first part (121) and a second part (21) to be connected together by the device (10) to form a vacuum cavity,
the device (10) comprising:
- heating means,
- a flange gasket,
- a first connection portion (13a) of the first part (121), comprising a first bearing face, and
- a second connection portion (13b) of the second part (21), comprising a second bearing face,
wherein said connection portions (13a, 13b) are arranged to be connected to each other at their bearing face, and
either of said connection portions (13a, 13b) comprises a gasket housing (313b) arranged to receive the flange gasket,
**characterized in that**:
- the heating means are arranged to heat the gasket housing (313b), and
the device (10) further comprises insulation means arranged to limit heat conduction from the heating means to the vacuum cavity, and
wherein the insulation means comprise, at the connection portions (13a, 13b), recesses (14a) separated by thin walls (14b) and arranged between the heating means and the cavity.

2. The connection device (10) according to the preceding claim, wherein the insulation means arranged to limit the heat conduction comprise at least one cooling housing arranged between the cavity and the heating means, and arranged to receive cooling means, such as a circulation of cooling fluid.

3. The connection device (10) according to any one of the preceding claims, wherein at least one of the connection portions (13a, 13b) comprises a beveled portion (113a, 113b) or a stepped portion at the bearing face on the side of the cavity, so as to produce a V-shaped or stepped notch when the first and the second connection portions (13a, 13b) are connected together.

4. The connection device (10) according to any one of the preceding claims, further comprising neutral gas injection means (16a, 16b) arranged at the gasket housing, on the side of the cavity, so as to obtain containment of the gasket by neutral gas overpressure.

5. The connection device (10) according to any one of the preceding claims, wherein:
- the first connection portion (13a) and the first part (121) are made in one piece, or
- the second connection portion (13b) and the second part (21) are made in one piece.

6. The connection device (10) according to claim 1, wherein:
the second part (21) comprises a cylindrical portion, such as a tank,
and
each of the connection portions (13a, 13b) has an annular shape arranged to extend radially and perpendicularly to the cylindrical portion outwardly, and
each of the connection portions (13a, 13b) comprises:
- a circular heating housing (213a, 213b) arranged to receive the heating means, such as heating coils,
- a circular cooling housing (15a, 15b) arranged between the cavity and the heating means, and arranged to receive cooling means, such as a circulation of cooling fluid,
- the recesses (14a), which are separated by the thin walls (14b) arranged between the circular cooling housing (15a, 15b) and the circular heating housing (213a, 213b),
- a beveled portion (113a, 113b) at the bearing face on the side of the cooling housing (15a, 15b), so as to produce a V-shaped notch when the connection portions (13a, 13b) are connected together, and wherein:
- the second part (21) has an internal diameter of at least 50 mm,
- the gasket housing (313b) is arranged at a diameter of at least 20 mm greater than the internal diameter and,
- the beveled portion (113a, 113b) has a slope over at least 5 mm in radius.

7. The connection device (10) according to the preceding claim, wherein:
- the second part (21) has an internal diameter of at least 250 mm,
- the gasket housing (313b) is arranged at a diameter of at least 350 mm, and
- the beveled portion (113a, 113b) has a slope over at least 15 mm in radius.

8. The connection device (10) according to any one of the preceding claims, wherein the gasket housing is arranged at a predetermined distance from the cavity greater than 20 mm, preferably greater than 30 mm, very preferably greater than 40 mm.

9. A vacuum deposition machine (20) comprising at least one connection device (10) according to any one of the preceding claims.
